(19) Europäisches Patentamt / European Patent Office / Office européen des brevets

(11) **EP 2 710 392 B1**

(12) **FASCICULE DE BREVET EUROPEEN**

(45) Date de publication et mention de la délivrance du brevet:
**04.07.2018 Bulletin 2018/27**

(21) Numéro de dépôt: **12728719.1**

(22) Date de dépôt: **16.05.2012**

(51) Int Cl.:
*G01R 31/36* (2006.01)   *B60L 11/18* (2006.01)

(86) Numéro de dépôt international:
**PCT/FR2012/051116**

(87) Numéro de publication internationale:
**WO 2012/160301 (29.11.2012 Gazette 2012/48)**

(54) **PROCEDE D'ESTIMATION DE L'ETAT DE CHARGE D'UNE BATTERIE ELECTRIQUE**

VERFAHREN ZUR SCHÄTZUNG DES LADUNGSZUSTANDS EINER ELEKTRISCHEN BATTERIE

METHOD OF ESTIMATING THE STATE OF CHARGE OF AN ELECTRIC BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.05.2011 FR 1101568**

(43) Date de publication de la demande:
**26.03.2014 Bulletin 2014/13**

(73) Titulaire: **Renault S.A.S.**
**92100 Boulogne-Billancourt (FR)**

(72) Inventeur: **DRIEMEYER-FRANCO, Ana-Lucia**
**F-78180 Montigny-le-Bretonneux (FR)**

(56) Documents cités:
EP-A1- 1 873 542       EP-A2- 1 993 185
EP-A2- 2 085 784       WO-A1-2005/111643
WO-A1-2006/135175      JP-A- 2004 014 205
JP-A- 2008 312 391     US-A1- 2005 057 255
US-A1- 2005 110 498    US-A1- 2007 236 182
US-A1- 2010 268 493

- CHENG K W E ET AL: "Battery-Management System (BMS) and SOC Development for Electrical Vehicles", IEEE TRANSACTIONS ON VEHICULAR TECHNOLOGY, IEEE SERVICE CENTER, PISCATAWAY, NJ, US, vol. 60, no. 1, 1 janvier 2011 (2011-01-01), pages 76-88, XP011342167, ISSN: 0018-9545, DOI: 10.1109/TVT.2010.2089647
- KIM H ET AL: "On Dynamic Reconfiguration of a Large-Scale Battery System", REAL-TIME AND EMBEDDED TECHNOLOGY AND APPLICATIONS SYMPOSIUM, 2009. RTAS 2009. 15TH IEEE, IEEE, PISCATAWAY, NJ, USA, 13 avril 2009 (2009-04-13), pages 87-96, XP031450847, ISBN: 978-0-7695-3636-1
- SRDJAN M LUKIC ET AL: "Charging ahead", IEEE INDUSTRIAL ELECTRONICS MAGAZINE, IEEE, US, vol. 2, no. 4, 1 décembre 2008 (2008-12-01), pages 22-31, XP011236963, ISSN: 1932-4529, DOI: 10.1109/MIE.2008.930361

**Description**

DOMAINE TECHNIQUE AUQUEL SE RAPPORTE L'INVENTION

La présente invention concerne le domaine des batteries électriques comportant une pluralité d'accumulateurs électriques.

Elle concerne plus particulièrement un procédé d'estimation de l'état de charge d'une telle batterie électrique.

Cette invention trouve une application particulièrement avantageuse pour l'estimation de l'état de charge d'une batterie électrique de traction d'un véhicule automobile.

ARRIERE-PLAN TECHNOLOGIQUE

Actuellement, l'état de charge d'une batterie électrique est estimé en fonction de mesures relatives à la batterie dans son ensemble, par exemple en fonction de la tension mesurée aux bornes de la batterie, du courant traversant la batterie et/ou de la température de la batterie.

Or, une batterie électrique comporte généralement plusieurs accumulateurs électriques appelés cellules qui présentent des caractéristiques différentes les uns des autres, comme par exemple la dispersion de leur capacité et de leur résistance interne.

Ces différences résultent d'une part de la construction de la batterie elle-même, et, d'autre part, du fait que les cellules subissent des variations de température différentes selon leur emplacement à l'intérieur de la batterie. Les caractéristiques des cellules qui dépendent de leur température subissent donc également des variations de température différentes.

En conséquence, les cellules formant une même batterie présentent fréquemment des états de charge différents. On parle alors de déséquilibre des cellules de la batterie.

Lorsque les cellules de la batterie présentent des états de charge différents, la plage d'utilisation de la batterie est imposée par la cellule la plus chargée et par la cellule la moins chargée.

En effet, la cellule la moins chargée de la batterie atteindra un état de charge nul, c'est-à-dire complètement déchargé, avant que les autres cellules ne soient complètement déchargées. La batterie dans son ensemble sera alors considérée comme déchargée alors que certaines cellules ne sont pas complétement déchargées. La plage d'utilisation de la batterie est donc limitée par l'écart entre la cellule la plus chargée et la cellule la moins chargée.

Dans cette situation de déséquilibre, l'estimation de l'état de charge de la batterie basée sur les caractéristiques mesurées de la batterie dans son ensemble, qui correspond grossièrement à une moyenne de l'état de charge des cellules, présente une imprécision importante. En particulier, cette estimation moyenne donne une valeur d'état de charge non nulle alors que la batterie est inutilisable, l'une des cellules étant complètement déchargée.

Cette imprécision de l'estimation de l'état de charge de la batterie est particulièrement préjudiciable dans le cas d'une batterie de traction d'un véhicule électrique ou hybride.

En effet, dans ces véhicules, l'information de l'état de charge de la batterie est directement affichée sur le tableau de bord du véhicule de sorte que le conducteur connaît l'autonomie de son véhicule.

L'autonomie d'un véhicule électrique étant inférieure à celle d'un véhicule thermique, il est important de rassurer le conducteur en lui fournissant l'information la plus fiable possible.

En outre, le conducteur doit pouvoir fonder ses décisions au cours de la conduite sur une information d'état de charge fiable. Une erreur d'estimation de l'état de charge de la batterie peut amener le conducteur à prendre une mauvaise décision et à se retrouver dans une situation désagréable, par exemple s'il se trouve immobilisé en raison d'un manque d'énergie, voire dans une situation dangereuse, par exemple s'il manque de puissance dans un dépassement.

Le document US 2005/0110498 divulgue une méthode d'estimation de la puissance électrique d'une batterie, comprenant les étapes de calculer les états de charge de chaque cellule, calculer une plage d'utilisation de la batterie en fonction de l'état de charge de la cellule la plus chargée et de l'état de charge de la cellule la moins chargée et calculer la puissance électrique globale de la batterie en fonction de ladite plage d'utilisation, de sorte à constituer un indicateur de l'état de charge global de la batterie.

OBJET DE L'INVENTION

Afin de remédier aux inconvénients précités de l'état de la technique, la présente invention propose un procédé permettant de fournir une estimation précise et fiable de l'état de charge d'une batterie.

Plus particulièrement, on propose selon l'invention un procédé d'estimation de l'état de charge d'une batterie électrique comportant une pluralité d'accumulateurs électrique appelés cellules, qui comprend les étapes suivantes :

a) on détermine l'état de charge de chaque cellule de la batterie,

b) on détermine une plage d'utilisation de la batterie égale à une valeur maximale prédéterminée de l'état de charge d'une cellule moins l'écart entre l'état de charge de la cellule la plus chargée et l'état de charge de la cellule la moins chargée déterminés à l'étape a),

c) on détermine l'état de charge de la batterie comme étant égal au rapport entre l'état de charge de la cellule la moins chargée déterminée à l'étape a) et ladite plage d'utilisation de la batterie déterminée à l'étape b).

Ce procédé d'estimation de l'état de charge de la batterie prend en compte le déséquilibre éventuel entre les cellules de la batterie.

Grâce à ce procédé, la valeur de l'état de charge estimé de la batterie indique une charge maximale, c'est-à-dire en pratique égale à 100%, lorsque la cellule la plus chargée présente un état de charge maximale, en pratique égal à 100%, et indique une charge minimale, en pratique égale à 0%, lorsque la cellule la moins chargée présente un état de charge minimal, en pratique égal à 0%.

En outre, le procédé selon l'invention permet d'obtenir une variation continue et représentative de l'état de charge de la batterie entre ces deux valeurs extrêmes.

D'autres caractéristiques non limitatives et avantageuses du procédé conforme à l'invention sont les suivantes :

- à l'étape a), on réalise les étapes suivantes pour chaque cellule de la batterie :

  a1) on détermine une valeur d'au moins une variable d'entrée représentative du fonctionnement de cette cellule,
  a2) on détermine une valeur d'au moins une variable de sortie représentative du fonctionnement de cette cellule,
  a3) on estime l'état de charge de la cellule, à l'aide d'un observateur d'état qui est basé sur la valeur déterminée à l'étape a1) de ladite variable d'entrée et qui est corrigé par un paramètre de correction déduit de la valeur déterminée à l'étape a2) de ladite variable de sortie ;

- ladite variable d'entrée comporte au moins le courant traversant la cellule ;
- ladite variable de sortie comporte au moins la tension aux bornes de la cellule ;
- chaque cellule est modélisée par un circuit électrique modèle comportant en série un générateur de tension, une résistance et un composant comprenant une résistance et un condensateur en parallèle ;
- les valeurs des résistances et de la capacité du condensateur du circuit électrique modèle dépendent de la température de la cellule (temp_cell) et/ou de l'état de charge de la cellule et/ou de la durée de vie de la cellule ;
- ledit observateur d'état comporte un filtre de Kalman ;
- ledit filtre de Kalman comporte au moins un paramètre dépendant du fonctionnement de la cellule ;
- ledit paramètre du filtre de Kalman dépend de la fonction reliant la tension de la cellule à vide et l'état de charge de la cellule ;
- la fonction reliant la tension de la cellule à vide et l'état de charge de la cellule est une fonction affine et ledit paramètre du filtre de Kalman est le taux d'accroissement de cette fonction ;
- la fonction reliant la tension de la cellule à vide et l'état de charge de la cellule est une fonction affine par morceaux et on utilise un filtre de Kalman différent pour chaque plage de valeur de l'état de charge de la cellule associée à une partie affine différente de la fonction reliant la tension de la cellule à vide et l'état de charge de la cellule ;
- le filtre de Kalman utilisé lors de la mise en oeuvre de l'étape a) à un instant donné est déterminé en fonction de la valeur de l'état de charge estimé de la cellule à l'instant précédent ;
- la transition entre un premier filtre de Kalman associé à une première plage de valeur de l'état de charge et un deuxième filtre de Kalman associé à une deuxième plage de valeurs de l'état de charge est gérée par un automate présentant une hystérésis ;
- à l'étape a), on détermine l'état de charge de chaque cellule par une méthode de comptage Ampére-heure-métrique, c'est-à-dire grâce à un compteur d'Ampère-heures ;
- à l'étape a),
- on intègre le courant entrant dans la batterie,
- on détermine l'état de charge de chaque cellule en fonction du rapport entre l'intégrale du courant entrant dans la batterie et la capacité de la cellule considérée ; et,
- la batterie considérée est une batterie de traction d'un véhicule automobile.

DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :

- la figure 1 représente schématiquement la détermination de l'état de charge de la batterie à partir de l'état de charge déterminé pour chaque cellule de la batterie,
- la figure 2 représente schématiquement le circuit électrique modélisant une des cellules de la batterie,
- la figure 3 représente schématiquement la tension à vide d'une cellule en fonction de l'état de charge de la cellule modélisé par le circuit de la figure 2 (trait plein), ainsi que son approximation à une fonction affine par morceaux (trait en pointillés),
- la figure 4 représente schématiquement la mise en oeuvre de quatre filtres de Kalman pour l'estimation de l'état de charge de la cellule modélisée par le circuit de la figure 2 correspondant chacun à une partie affine différente de la fonction représentative de la tension à vide de cette cellule en fonction de l'état de charge de cette cellule,
- la figure 5 montre l'évolution de l'état de charge de la batterie estimé par le procédé selon l'invention en fonction du temps (trait plein) et l'évolution de l'état de charge des cellules de la batterie correspondante (traits pointillés), en l'absence de système d'équilibrage des cellules,
- la figure 6 montre l'évolution de l'état de charge de la batterie estimé par le procédé selon l'invention en fonction du temps (trait plein) et l'évolution de l'état de charge des cellules de la batterie correspondante (traits pointillés), en présence d'un système d'équilibrage des cellules.

On considère ici une batterie électrique comportant une pluralité d'accumulateurs électriques connectés en série et appelés dans la suite cellules.

Cette batterie électrique est par exemple une batterie de traction d'un véhicule automobile électrique ou hybride. Elle comporte un nombre de cellules quelconque, par exemple égal à 96.

On notera dans la suite avec l'indice i les grandeurs et les opérateurs associés à la cellule d'indice i, avec i prenant les valeurs de 1 à 96.

L'état de charge de la batterie ou d'une cellule est couramment exprimé en pourcentage de l'état de charge maximal de cette batterie ou de cette cellule.

Dans la suite, un état de charge égal à 100% indiquera donc une batterie ou une cellule complètement chargée, et donc un état de charge maximal.

Un état de charge de 0% indiquera une batterie ou une cellule complètement déchargée, et donc un état de charge minimal.

En pratique, l'estimation de l'état de charge de la batterie est réalisée à différents instants, de préférence à intervalles de temps réguliers de période Te, à partir d'un instant initial t0. On notera dans la suite par l'indice k l'ensemble des mesures et calculs réalisés à un instant donné $t\_k = t0 + k.Te$. Lorsque l'indice de temps est omis, la valeur de la variable est considérée à l'instant k de la mesure ou du calcul en cours.

Le procédé selon l'invention est mis en oeuvre par une unité de commande électronique. Cette unité de commande électronique est adaptée à recevoir des informations provenant de capteurs de la batterie adaptés à mesurer différentes valeurs de tension, d'intensité et de température à l'intérieure de la batterie, comme indiqué plus loin.

Selon l'invention, le procédé d'estimation de l'état de charge noté SOCbatt_k de la batterie électrique comporte les étapes suivantes :

a) on détermine l'état de charge noté SOCcell_est_i de chaque cellule de la batterie,

b) on détermine une plage d'utilisation de la batterie égale à une valeur maximale prédéterminée de l'état de charge d'une cellule moins l'écart entre l'état de charge de la cellule la plus chargée noté SOCcell_max_k et l'état de charge de la cellule la moins chargée noté SOCcell_min_k, soit l'écart entre la plus grande valeur d'état de charge SOCcell_est_i déterminée à l'étape a) pour l'une des cellules de la batterie et la plus petite valeur d'état de charge SOCcell_est_i déterminée à l'étape a) pour une autre des cellules de la batterie,

c) on détermine l'état de charge de la batterie SOCbatt_k comme étant égal au rapport entre l'état de charge de la cellule la moins chargée déterminée à l'étape a) et ladite plage d'utilisation de la batterie déterminée à l'étape b).

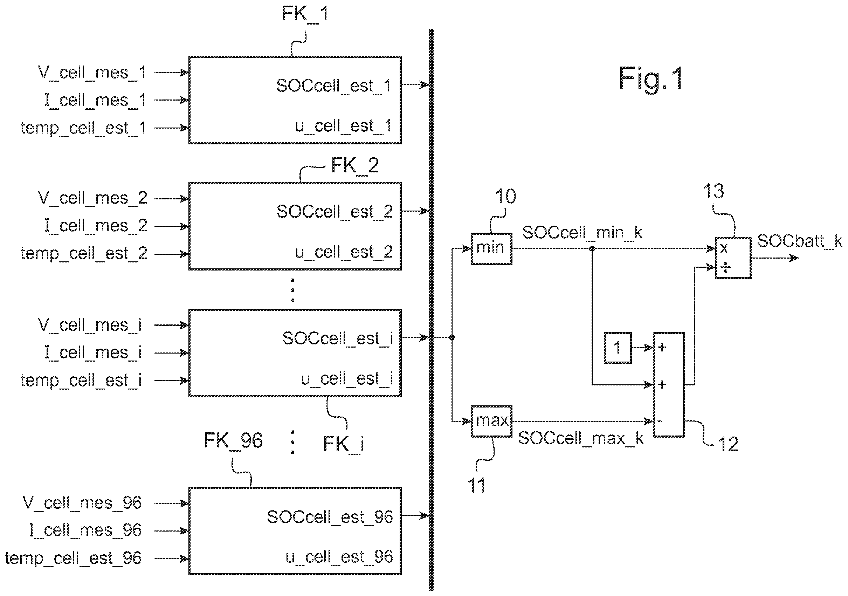

Ces trois étapes sont représentées sur la figure 1.

La partie gauche de la figure 1 représente la détermination de la valeur de l'état de charge SOCcell_est_i de chaque cellule de la batterie à l'instant t_k considéré à l'étape a).

Ici, la valeur de l'état de charge SOCcell_est_i de chaque cellule est estimée par un observateur qui est ici un filtre de Kalman FK_i associé à ladite cellule d'indice i, à l'instant t_k.

Ce faisant, l'unité de commande électronique détermine, à chaque instant t_k, l'état de charge de la cellule la plus chargée SOCcell_max_k et l'état de charge de la cellule la moins chargée SOCcell_min_k à cet instant, selon les formules suivantes :

$$SOCcell\_min\_k = min(SOCcell\_est\_i) \text{ pour } i = 1 \text{ à } 96$$

et

$$SOCcell\_max\_k = max(SOCcell\_est\_i) \text{ pour } i = 1 \text{ à } 96.$$

Cette étape est représentée par les blocs 10 et 11 de la figure 1.

L'unité de commande électronique détermine à l'étape b) la plage d'utilisation de la batterie à l'instant t_k, égale à la valeur maximale prédéterminée de l'état de charge d'une cellule moins l'écart entre l'état de charge de la cellule la plus chargée SOCcell_max_k et l'état de charge de la cellule la moins chargée SOCcell_min_k.

La valeur maximale prédéterminée de l'état de charge d'une cellule quelconque est par exemple fixée et égale à 100%.

Le bloc 12 de la figure 1 réalise le calcul de cette plage d'utilisation.

L'unité de commande électronique détermine enfin à l'étape c) l'état de charge de la batterie SOCbatt_k à l'instant t_k en calculant le rapport entre :

-   l'état de charge SOCcell_min_k de la cellule la moins chargée à l'instant t_k,
-   et la plage d'utilisation déterminée.

Cette opération est réalisée par le bloc 13 sur la figure 1.

En d'autres termes, l'état de charge SOCbatt de la batterie est déterminé selon la formule :

$$SOCbatt\_k = SOCcell\_min\_k / (1 - ( SOCcell\_max\_k - SOCcell\_min\_k ).$$

L'étape a) de détermination de l'état de charge SOCcell_est_i de chaque cellule de la batterie à l'instant t_k considéré peut être réalisée de différentes manières.

Selon un mode de réalisation préféré de l'invention, à l'étape a), on réalise les étapes suivantes pour chaque cellule de la batterie :

a1) on détermine une valeur I_cell_mes_i d'au moins une variable d'entrée i_cell représentative du fonctionnement de cette cellule,

a2) on mesure une valeur V_cell_mes_i d'au moins une variable de sortie u_cell représentative du fonctionnement de cette cellule,

a3) on estime l'état de charge de la cellule SOCcell_est_i à l'aide d'un observateur d'état qui est basé sur la valeur déterminée à l'étape a1) de ladite variable d'entrée i_cell et qui est corrigé par un paramètre de correction déduit de la valeur mesurée à l'étape a2) de ladite variable de sortie u_cell.

En outre, on détermine également de préférence une température temp_cell_est_i de la cellule et on estime à l'étape a3) la charge de la cellule en fonction de cette température.

Ces étapes sont répétées à chaque instant t_k, pour chaque cellule d'indice i.

Plus précisément, ladite variable d'entrée comporte au moins le courant traversant la cellule i_cell.

Lorsque la batterie ne comporte pas de système d'équilibrage des charges des cellules, cette variable est identique au courant $I_{bat}$ traversant la batterie elle-même car les cellules étant connectées entre elles en série, le courant traversant la batterie est égal au courant traversant chaque cellule.

Si un système d'équilibrage des charges des cellules est mis en oeuvre pour uniformiser les charges des différentes cellules à tout instant, le courant i_cell correspond au courant $I_{bat}$ auquel s'ajoute le courant d'équilibrage de la cellule car ce système d'équilibrage est connecté en parallèle à la cellule.

Ladite variable de sortie comporte au moins la tension aux bornes de la cellule u_cell.

Ces variables d'entrée et de sortie sont déterminées pour chaque cellule d'indice i à chaque instant t_k. Elles sont de préférence mesurées.

Dans l'observateur d'état choisi, on dispose alors au moins :

-   d'une variable d'entrée i_cell dont la valeur est mesurée à chaque instant t_k pour mettre à jour les calculs à chaque pas de temps,
-   d'une variable d'état SOCcell qui est l'état de charge de la cellule dont l'estimation SOCcell_est est recherchée,
-   d'une variable de sortie u_cell dont une valeur est estimée par l'observateur et comparée à une valeur mesurée de cette variable de sortie, pour corriger l'observateur de manière à le faire tendre au plus près de la réalité.

Dans cet observateur d'état, la variable d'état dont on cherche à déterminer les valeurs est donc calculée à chaque pas de temps non seulement à l'aide de la variable d'entrée mesurée, mais également en fonction d'un paramètre de correction déduit de la variable de sortie.

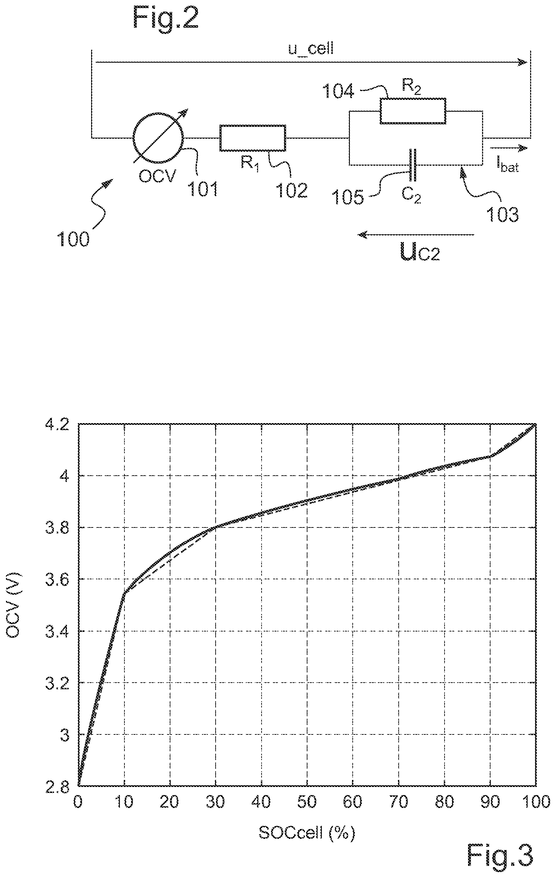

Plus précisément, pour la mise en oeuvre de ce mode de réalisation, chaque cellule est modélisée par un circuit électrique modèle 100. Un exemple d'un tel circuit électrique modèle 100 est représenté sur la figure 2.

Il comporte en série un générateur de tension 101 générant une tension OCV, une résistance 102 de valeur R1 et un composant 103 comprenant une résistance 104 de valeur R2 et un condensateur 105 de capacité C2 en parallèle.

R1 correspond à la résistance interne de la cellule, R2 et C2 sont utilisés pour modéliser des phénomènes en fréquence à l'intérieur de la cellule.

La tension aux bornes du composant 103 est notée dans la suite $U_{C2}$.

La tension aux bornes de ce circuit modèle en circuit fermé est la tension u_cell aux bornes de la cellule correspondante. La tension aux bornes de ce circuit modèle en circuit ouvert est la tension OCV qui correspond à la tension de la cellule en circuit ouvert.

Le courant traversant ce circuit modèle est le courant traversant la cellule correspondante i_cell.

Les valeurs R1, R2 des résistances 102, 104 et la valeur C2 de la capacité du condensateur 105 du circuit électrique modèle 100 dépendent de préférence de la valeur temp_cell_est_i la température temps_cell de la cellule d'indice i et/ou de l'état de charge SOCcell de la cellule modélisée par le circuit modèle considéré et/ou de la durée de vie de la cellule.

La durée de vie de la cellule correspond par exemple au temps écoulé depuis sa fabrication ou au temps écoulé depuis sa mise en service dans le véhicule électrique. Il s'agit d'un paramètre permettant de quantifier la perte de capacité de la cellule depuis le début de son utilisation. En effet, le processus de vieillissement de la cellule entraîne une diminution de la capacité de la cellule.

Pour prendre en compte la durée de vie de la cellule à un instant t, il est possible de déterminer la capacité instantanée de la cellule à cet instant et de calculer un paramètre égale à cette capacité instantanée divisée par la capacité initiale de la cellule au début de son utilisation.

Ce paramètre est ensuite utilisé pour déterminer les valeurs R1, R2 des résistances 102, 104 et/ou la valeur C2 de la capacité du condensateur 105 du circuit électrique modèle 100.

En pratique, ces valeurs R1, R2 et C2 constituent des paramètres de l'observateur d'état et sont déterminées par l'unité de commande à partir de cartographies pré-établies, en fonction de la valeur temp_cell_est_i de la température temp_cell de la cellule d'indice i à l'instant t_k et en fonction de l'état de charge de la cellule estimé pour l'instant t_k au pas de calcul précédent. La valeur de la température temp_cell_est_i peut être mesurée, déterminée par calcul ou estimée à partir d'autres informations sur le fonctionnement de la cellule.

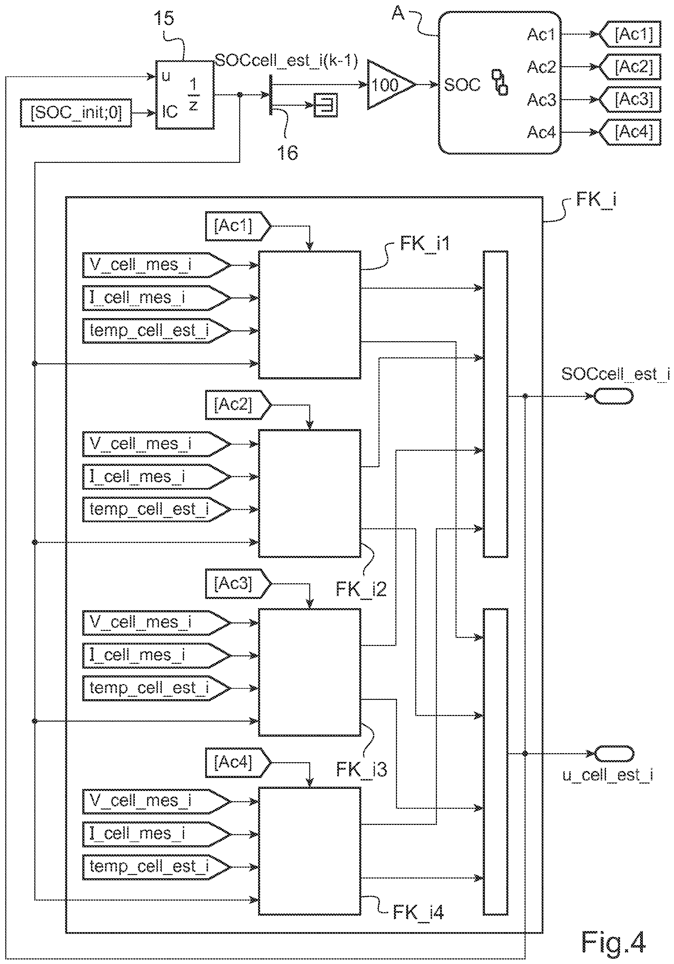

L'observateur d'état FK_i associé à la cellule d'indice i accepte donc en entrée la valeur I_cell_mes_i de la variable d'entrée i_cell, la valeur V_cell_mes_i de la variable de sortie u_cell et la valeur temp_cell_est_i de la température temp_cell de la cellule d'indice i, comme représentée sur la figure 4.

L'observateur d'état comporte par exemple un filtre de Kalman.

Ce filtre de Kalman comporte au moins un paramètre dépendant du fonctionnement de la cellule, par exemple de la fonction reliant la tension de la cellule à vide OCV, qui correspond à la tension générée par le générateur de tension 101 dans le circuit modèle 100, et l'état de charge SOCcell de la cellule.

La tension à vide d'une cellule OCV est une fonction non-linéaire de son état de charge SOCcell, et différente pour chaque chimie de cellule. Un exemple est donné en figure 3 en trait plein.

Il est possible de faire une approximation affine par morceaux de cette fonction, représenté en trait pointillé sur la figure 3.

On peut alors définir une pluralité de plages de valeurs de l'état de charge de la cellule SOCcell pour lesquelles cette fonction est une fonction affine.

On a alors sur chaque intervalle d'états de charge considéré, OCV(SOCcell) = a . SOCcell + b, avec a et b deux paramètres caractéristiques de la cellule et de la plage d'états de charge considérée.

Dans la suite, la capacité totale en Ampère heure (noté Ah) de la cellule modélisée par le circuit modèle 100 est notée $Q_{max}$.

La capacité totale est une caractéristique intrinsèque de chaque cellule, et dépend de la température de la cellule et de sa durée de vie. Les cellules d'une batterie ont des capacités similaires, mais pas nécessairement identiques.

Le fonctionnement du circuit modèle 100 et donc de la cellule correspondante est décrit par les équations suivantes :

$$\frac{dU_{C2}(t)}{dt} = -\frac{U_{C2}(t)}{R2.C2} + \frac{I_{bat}(t)}{C2}$$

$$\frac{dSOCcell(t)}{dt} = \frac{I_{bat}(t)}{Q_{max}}$$

$$u\_cell(t) = OCV(SOCcell(t)) + R1.I_{bat}(t) + U_{C2}(t).$$

Avec un modèle discrétisé par la méthode d'Euler comportant un temps d'échantillonnage égal à la période Te et où chaque pas de calcul correspond à un instant t_k et est représenté par l'indice k, la cellule est donc décrite par le système d'équation :

$$\begin{cases} x_{k+1} = A_s x_k + B_s u_k \\ y_k = C_s x_k + D_s u_k \end{cases}$$

où

$$x_k = \begin{bmatrix} SOCcell_k \\ U_{C2,k} \end{bmatrix}, \; y_k = u\_cell_k - b, \; u_k = I_{bat,k}$$

$$A_s = \begin{bmatrix} 1 & 0 \\ 0 & \left(1 - \frac{Te}{R2.C2}\right) \end{bmatrix}, \; B_s = \begin{bmatrix} \frac{Te}{Q_{max}} \\ \frac{Te}{C2} \end{bmatrix}, \; C_s = \begin{bmatrix} a & 1 \end{bmatrix}, \; D_s = R1$$

Dans ce système d'équation, $u_k$ représente la variable d'entrée du filtre de Kalman, c'est-à-dire ici le courant aux bornes de la cellule qui est égal au courant aux bornes de la batterie auquel s'ajoute éventuellement le courant d'équilibrage de la cellule lorsqu'un système d'équilibrage est mis en oeuvre, $x_k$ représente l'état du système, c'est-à-dire ici l'état de charge de la cellule et la tension $U_{C2}$ aux bornes du composant 103 et $y_k$ représente la variable de sortie. Cette variable de sortie donne accès à une valeur estimée u_cell_est_i de la tension aux bornes de la cellule d'indice i à l'instant k.

Les matrices $A_s$, $B_s$ et $D_s$ sont mises à jour à chaque pas de calcul, c'est-à-dire à chaque instant t_k, puisqu'elles dépendent des paramètres R1, R2 et C2, qui varient en fonction de la valeur temps_cell_est_i de la température temp_cell de la cellule et de l'état de charge SOCcell de cette cellule.

Comme expliqué précédemment, les paramètres R1, R2 et C2 sont donnés par des cartographies.

Lors de la réalisation de l'étape a) par mise en oeuvre du filtre de Kalman, on réalise tout d'abord une estimation des valeurs des variables d'état et de sortie du filtre de Kalman. Pour cela, on calcule l'état prédit $\hat{x}_{k+1\|k}$ à l'instant t_(k+1) en fonction de l'état à l'instant t_k, grâce aux équations caractéristiques de la mise en oeuvre du filtre de Kalman :

$$\hat{x}_{k+1\|k} = A_s \hat{x}_{k\|k} + B_s u_k$$

$$\hat{y}_{k+1\|k} = C_s \hat{x}_{k\|k} + D_s u_k$$

Ensuite, le gain optimal $K_{k+1}$ du filtre de Kalman est calculé à partir des équations suivantes, dans lesquelles $P_{k+1\|k}$ et $P_{k+1\|k+1}$ sont des variables intermédiaires bien connues de l'homme du métier :

$$P_{k+1\|k} = A_s P_{k\|k} A_s^{T} + Q_{kal}$$

$$P_{k+1\|k+1} = P_{k+1\|k} - K_{k+1}\left(C_s P_{k+1\|k} C_s^{\;T} + R_{kal}\right)K_{k+1}^{\;T}$$

$$K_{k+1} = P_{k+1\|k} C_s^{\;T}\left(C_s P_{k+1\|k} C_s^{\;T} + R_{kal}\right)^{-1}$$

où

- $A_s^{\;T}$ et $C_s^{\;T}$ sont les matrices transposées des matrices $A_s$ et $C_s$,
- $Q_{kal}$ et $R_{kal}$ correspondent respectivement à la variance de l'état et à la variance de la sortie. Ces deux paramètres constituent des éléments de réglage du filtre de Kalman.

Plus précisément $P_{k+1\|k}$ est la matrice d'estimation prédite de la covariance de l'erreur sur l'état prédit et $P_{k+1\|k+1}$ est la matrice d'estimation a posteriori de la covariance de cette erreur.

Enfin, l'état prédit $\hat{x}_{k+1\|k}$ est corrigé en fonction de l'erreur sur la sortie estimée, c'est-à-dire en fonction de la différence entre la valeur mesurée de la variable de sortie $y_{k+1}$ et la valeur prédite $\hat{y}_{k+1\|k}$ de cette sortie, en faisant le calcul suivant :

$$\hat{x}_{k+1\|k+1} = \hat{x}_{k+1\|k} + K_{k+1}\left(y_{k+1} - \hat{y}_{k+1\|k}\right).$$

Le filtre de Kalman donne ainsi accès à une valeur estimée SOCcell_est_i de l'état de charge SOCcell de la cellule d'indice i et à une valeur estimée u_cell_est_i de la tension u_cell aux bornes de la cellule d'indice i.

Cette valeur estimée u_cell_est_i de la tension aux bornes de la cellule est égale à $\hat{y}_{k+1\|k}$ +b (voir figures 1 et 4).

Comme le montrent les équations ci-dessus, le taux d'accroissement noté « a » de la fonction affine reliant la tension à vide OCV et l'état de charge de la cellule est un paramètre du filtre de Kalman utilisé pour déterminer l'état de charge de la cellule.

On utilise donc un filtre de Kalman différent pour chaque plage de valeur de l'état de charge de la cellule associée à une partie affine différente de la fonction reliant la tension de la cellule à vide OCV et l'état de charge de la cellule.

Le filtre de Kalman utilisé lors de la mise en oeuvre de l'étape a) à un instant donné t_k est donc déterminé en fonction de la valeur de l'état de charge estimé de la cellule à l'instant précédent t_(k-1).

Dans l'exemple représenté sur la figure 3, la courbe représentative de la tension à vide OCV de la cellule en fonction de son état de charge est approximée par quatre zones affines différentes, correspondant respectivement à une plage de valeurs d'état de charge comprise entre 0 et 10%, 10 et 30%, 30 et 90%, 90 et 100%. Un filtre de Kalman différent est donc utilisé pour chacune de ces plages de valeurs d'état de charge de la cellule considérée.

En conséquence, dans l'exemple développé ici, pour la détermination de l'état de charge de la cellule représentée à la figure 2 et dont la courbe représentative de la tension à vide OCV de la cellule en fonction de son état de charge est représentée figure 3, quatre filtres de Kalman sont utilisés, selon la plage de valeur de l'état de charge de la cellule.

Ces différents filtres de Kalman sont activés en alternance. Un exemple de mise en oeuvre de ces différents filtres est représenté sur la figure 4, pour une cellule d'indice i.

Comme représenté sur cette figure, le filtre de Kalman FK_i correspondant à cette cellule d'indice i comporte quatre filtres de Kalman FK_i1, FK_i2, FK_i3 et FK_i4. Chacun de ces filtres est adapté à recevoir en entrée les valeurs de la tension aux bornes de la cellule d'indice i, du courant traversant cette cellule et de la température de la cellule, ainsi que les valeurs des variables d'état et de sortie estimées à l'instant précédent.

A cet égard, le bloc 15 de la figure 4 accepte en entrée la valeur du vecteur $x_k$ estimée à l'instant k et donne en sortie la valeur du vecteur $x_{k-1}$ estimée à l'instant précédent. Comme indiqué sur cette figure, le vecteur $x_0$ d'initialisation à l'instant t0 est le vecteur (SOC_ini, 0), où SOC_ini est la valeur d'initialisation du calcul.

La transition entre deux plages de valeurs, et donc entre deux filtres de Kalman différents, est gérée par un automate A comportant des hystérésis de manière à empêcher l'oscillation entre deux filtres de Kalman.

Cet automate A accepte en entrée la valeur SOCcell_est_i(k-1) déterminée à l'instant précédent le calcul en cours (figure 4, le bloc 16 indique que seule la valeur de la première coordonnée du vecteur est retenue) pour la cellule d'indice i considérée. L'automate A émet en sortie un signal d'activation de l'un des filtres de Kalman FK_i1, FK_i2, FK_i3, FK_i4 noté respectivement Ac1, Ac2, Ac3 ou Ac4, selon que la valeur de l'état de charge à l'instant précédent SOCcell_est_i(k-1) est comprise dans l'une ou l'autre des quatre plage de valeurs d'états de charge définies plus haut.

Seul le filtre pour lequel le signal d'activation est émis est activé.

Afin d'éviter l'oscillation entre deux filtres de Kalman correspondants à deux plages de valeurs d'état de charge voisines, la transition d'un filtre à l'autre n'est pas déclenché autour d'une valeur seuil simple.

Cette transition est déclenchée avec une hystérésis.

Plus précisément, la transition entre deux filtres de Kalman correspondants à deux plages de valeurs d'états de charge est déclenchée lorsque l'état de charge de la cellule correspondante atteint une valeur seuil qui est différente selon le sens de variation de cet état de charge à cet instant.

Par exemple, on passe d'un premier filtre de Kalman correspondant à une première plage de valeurs d'état de charge à un deuxième filtre de Kalman correspondant à une deuxième plage de valeurs d'état de charge lorsque la valeur estimée de l'état de charge de la cellule atteint un premier seuil si l'état de charge augmente.

En revanche, on repasse du deuxième filtre de Kalman au premier filtre de Kalman lorsque la valeur estimée de l'état de charge atteint un deuxième seuil différent dudit premier seuil si l'état de charge diminue.

Le deuxième seuil est de préférence inférieur au premier seuil.

Par exemple, si l'on considère des valeurs d'état de charge proche du seuil de 10% entre les première et deuxième plage correspondant respectivement à 0-10% et 10-30%, la transition entre le filtre FK_i1 correspondant à la première plage et celui correspondant à la deuxième plage FK_i2 est déclenché lorsque la valeur de l'état de charge estimée augmente pour atteindre 10%. En revanche, le retour au premier filtre FK_i1 n'est pas déclenché lorsque la valeur de l'état de charge estimée diminue et passe en dessous de 10%, mais plutôt lorsqu'elle diminue pour atteindre par exemple 9%, c'est-à-dire une valeur seuil inférieure à 10%.

Lors d'une telle transition, le filtre de Kalman est initialisé avec la valeur de l'état de charge SOCcell_est_i(k-1) précédemment calculée pour garantir une transition lisse et donc une variation continue de la valeur de l'état de charge estimée.

Pour améliorer la précision de l'estimation, les paramètres Qkal et Rkal de chaque filtre de Kalman FK_i et FK_i1, FK_i2, FK_i3, FK_i4 si plusieurs filtres sont utilisés pour une même cellule, sont réglés indépendamment pour chaque plage de valeurs de l'état de charge.

Selon un autre mode de réalisation possible, à l'étape a), on détermine l'état de charge de chaque cellule par une méthode de comptage Ampère-heure-métrique, c'est-à-dire de comptage des Ampère heures.

Plus précisément, selon cet autre mode de réalisation,

- on intègre le courant entrant dans la batterie,
- on détermine l'état de charge de chaque cellule à partir du rapport entre l'intégrale du courant entrant dans la batterie et la capacité de la cellule considérée.

De manière particulièrement avantageuse, la batterie considérée est une batterie de traction d'un véhicule automobile électrique ou hybride.

L'unité de commande est alors intégrée à l'unité de commande du véhicule et reçoit les informations transmises par les différents capteurs de ce véhicule.

Une fois l'état de charge SOCcell de chaque cellule obtenu, l'état de charge est déterminé selon l'étape c) décrite précédemment.

Le procédé selon l'invention permet d'obtenir une valeur d'état de charge de batterie égal à 100% lors que l'état de charge de la cellule la plus chargée est de 100%, une valeur d'état de charge égale à 0% lors que l'état de charge de la cellule la moins chargée est de 0%, et une évolution continue et représentative de l'état de charge de la batterie entre ces deux valeurs extrêmes.

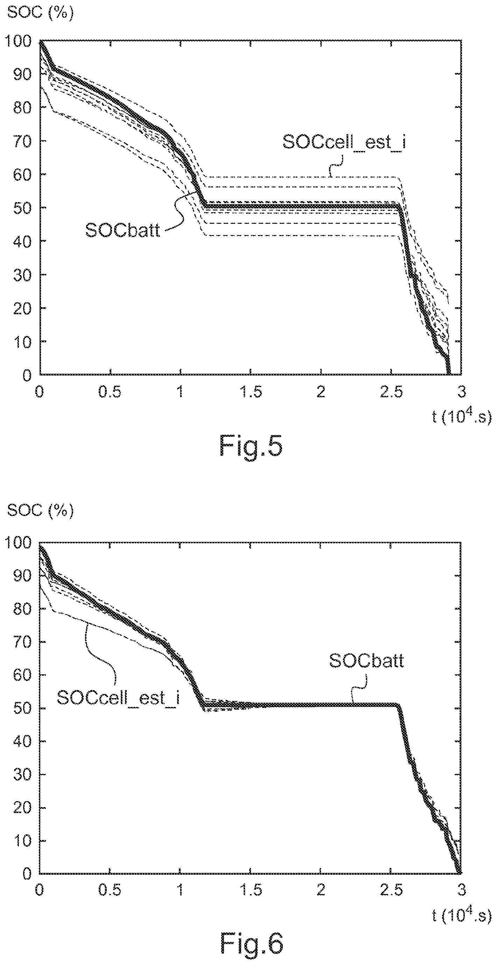

Ceci est visible sur la figure 5 montrant l'évolution en fonction du temps de l'état de charge de la batterie (trait plein) estimée selon le procédé et de l'état de charge de plusieurs cellules (traits pointillé), pour un cycle de décharge de la batterie.

L'évolution de l'état de charge de la batterie suit précisément celui des cellules et les conditions initiales et finales énoncées précédemment sont remplies.

Le procédé décrit ici peut être utilisé pour une batterie comportant un système d'équilibrage ayant pour but de permettre l'utilisation de la batterie sur une plage d'utilisation maximale pour augmenter l'autonomie du véhicule. Un tel système est bien connu de l'homme du métier.

Pour une situation initiale identique à celle de la batterie dans la figure 5, c'est-à-dire un déséquilibre initial identique des cellules de la batterie, en présence d'un système d'équilibrage, l'estimation de l'état de charge de la batterie en fonction du temps est représenté en trait plein sur la figure 6. L'évolution, en fonction du temps, de l'état de charge des cellules correspondant est représentée en trait pointillé. La présence du système d'équilibrage rend l'estimation de l'état de charge de la batterie selon le procédé encore plus précis, car cette estimation est très proche de la valeur de l'état de de charge de chaque cellule sur une grande partie du temps d'utilisation.

En variante, lors de la réalisation de l'étape a) selon le premier mode de réalisation, il est possible d'augmenter l'ordre du filtre de Kalman utilisé, par exemple d'utiliser un filtre d'ordre 3. Il est également possible d'envisager l'utilisation d'un observateur adaptatif qui estime les paramètres R1, R2 et C2 à chaque pas de calcul au lieu d'utiliser des valeurs issues de cartographies.

Si le procédé est mis en oeuvre en présence d'un système d'équilibrage, il est possible de prendre en compte l'efficacité du système d'équilibrage pour corriger la valeur estimée de l'état de charge de la batterie. Dans ce cas, l'état de charge estimé de la batterie sera plus élevé dès le début de l'équilibrage.

Le procédé trouve une application particulièrement avantageuse pour l'estimation de l'état de charge de la batterie de traction d'un véhicule automobile électrique ou hybride.

En effet, l'information de l'état de charge de la batterie est affichée au conducteur par l'intermédiaire d'une jauge batterie du tableau de bord.

Le conducteur doit pouvoir se baser sur ces informations pour prendre les décisions relatives à la conduite du véhicule en toute sécurité. Il est notamment important de lui fournir une information précise lorsque l'état de charge est faible, afin d'éviter qu'il ne se retrouve en panne d'énergie ou en manque de puissance moteur.

Dans le cas où le procédé est mis en oeuvre en présence d'un système d'équilibrage, l'état de charge étant plus élevé avec l'équilibrage, l'autonomie kilométrique du véhicule affichée au conducteur augmentera au fur et à mesure que l'équilibrage a lieu.

**Revendications**

1. Procédé d'estimation de l'état de charge (SOCbatt_k) d'une batterie électrique comportant une pluralité d'accumulateurs électriques appelés cellules, **caractérisé en ce qu'**il comporte les étapes suivantes :

   a) on détermine l'état de charge (SOCcell_est_i) de chaque cellule de la batterie,
   b) on détermine une plage d'utilisation de la batterie égale à une valeur maximale prédéterminée de l'état de charge d'une cellule moins l'écart entre l'état de charge (SOCcell_max_k) de la cellule la plus chargée et l'état de charge de la cellule la moins chargée (SOCcell_min_k) déterminés à l'étape a),
   c) on détermine l'état de charge de la batterie (SOC_batt_k) comme étant égal au rapport entre l'état de charge de la cellule la moins chargée (SOCcell_min_k) déterminée à l'étape a) et ladite plage d'utilisation de la batterie déterminée à l'étape b).

2. Procédé selon la revendication 1, selon lequel, à l'étape a), on réalise les étapes suivantes pour chaque cellule de la batterie :

   a1) on détermine une valeur (I_cell_mes) d'au moins une variable d'entrée (i_cell) représentative du fonctionnement de cette cellule,
   a2) on détermine une valeur (V_cell_mes) d'au moins une variable de sortie (u_cell) représentative du fonctionnement de cette cellule,
   a3) on estime l'état de charge de la cellule (SOCcell_est_i), à l'aide d'un observateur d'état qui est basé sur la valeur déterminée à l'étape a1) de ladite variable d'entrée (i_cell) et qui est corrigé par un paramètre de correction déduit de la valeur déterminée à l'étape a2) de ladite variable de sortie (u_cell).

3. Procédé selon la revendication 2, selon lequel ladite variable d'entrée comporte au moins le courant traversant la cellule (i_cell).

4. Procédé selon l'une des revendications 2 et 3, selon lequel ladite variable de sortie comporte au moins la tension aux bornes de la cellule (u_cell).

5. Procédé selon l'une des revendications 2 à 4, selon lequel chaque cellule est modélisée par un circuit électrique modèle comportant en série un générateur de tension (OCV), une résistance (R1) et un composant comprenant une résistance (R2) et un condensateur (C2) en parallèle.

6. Procédé selon la revendication 5, selon lequel les valeurs des résistances (R1, R2) et de la capacité (C2) du condensateur du circuit électrique modèle dépendent de la température de la cellule (temp_cell) et/ou de l'état de charge (SOCcell) de la cellule et/ou de la durée de vie de la cellule.

7. Procédé selon l'une des revendications 2 à 6, selon lequel ledit observateur d'état comporte un filtre de Kalman (FK_i).

8. Procédé selon la revendication 7, selon lequel ledit filtre de Kalman (FK_i) comporte au moins un paramètre dépendant du fonctionnement de la cellule.

9. Procédé selon la revendication précédente, selon lequel ledit paramètre du filtre de Kalman (FK_i) dépend de la fonction reliant la tension de la cellule à vide (OCV) et l'état de charge de la cellule.

10. Procédé selon la revendication précédente, selon lequel la fonction reliant la tension de la cellule à vide (OCV) et l'état de charge de la cellule est une fonction affine et ledit paramètre du filtre de Kalman (FK_i) est le taux d'accroissement (a) de cette fonction.

11. Procédé selon la revendication 9, selon lequel la fonction reliant la tension de la cellule à vide (OCV) et l'état de charge de la cellule est une fonction affine par morceaux et on utilise un filtre de Kalman (FK_i1, FK_i2, FK_i3, FK_i4) différent pour chaque plage de valeur de l'état de charge de la cellule associée à une partie affine différente de la fonction reliant la tension de la cellule à vide (OCV) et l'état de charge de la cellule.

12. Procédé selon la revendication précédente, selon lequel le filtre de Kalman (FK_i1, FK_i2, FK_i3, FK_i4) utilisé lors de la mise en oeuvre de l'étape a) à un instant donné est déterminé en fonction de la valeur de l'état de charge estimé (SOCcell_est_i) de la cellule à l'instant précédent.

13. Procédé selon l'une des revendications 11 et 12, selon lequel la transition entre un premier filtre de Kalman associé à une première plage de valeur de l'état de charge et un deuxième filtre de Kalman associé à une deuxième plage de valeurs de l'état de charge est gérée par un automate (A) présentant une hystérésis.

14. Procédé selon la revendication 1, selon lequel, à l'étape a), on détermine l'état de charge de chaque cellule par une méthode de comptage Ampère-heure-métrique.

15. Procédé selon la revendication précédente, selon lequel, à l'étape a),

- on intègre le courant entrant dans la batterie,
- on détermine l'état de charge de chaque cellule en fonction du rapport entre l'intégrale du courant entrant dans la batterie et la capacité de la cellule considérée.

16. Procédé selon l'une des revendications précédentes, selon lequel la batterie considérée est une batterie de traction d'un véhicule automobile.

**Patentansprüche**

1. Verfahren zur Schätzung des Ladezustands (SOCbatt_k) einer elektrischen Batterie, welche mehrere elektrische Akkumulatoren, Zellen genannt, aufweist, **dadurch gekennzeichnet, dass** es die folgenden Schritte umfasst:

a) es wird der Ladezustand (SOCcell_est_i) jeder Zelle der Batterie bestimmt,
b) es wird ein Verwendungsbereich der Batterie bestimmt, der gleich einem vorbestimmten maximalen Wert des Ladezustands einer Zelle abzüglich der Abweichung zwischen dem Ladezustand (SOCcell_max_k) der am stärksten geladenen Zelle und dem Ladezustand der am wenigsten geladenen Zelle (SOCcell_min_k), die in Schritt a) bestimmt wurden, ist,
c) es wird der Ladezustand der Batterie (SOC_batt_k) als gleich dem Verhältnis zwischen dem Ladezustand der am wenigsten geladenen Zelle (SOCcell_min_k), der in Schritt a) bestimmt wurde, und dem Verwendungsbereich der Batterie, der in Schritt b) bestimmt wurde, bestimmt.

2. Verfahren nach Anspruch 1, wobei in Schritt a) die folgenden Schritte für jede Zelle der Batterie durchgeführt werden:

a1) es wird ein Wert (I_cell_mes) wenigstens einer Eingangsvariablen (i_cell) bestimmt, die für die Funktionsweise dieser Zelle repräsentativ ist,
a2) es wird ein Wert (V_cell_mes) wenigstens einer Ausgangsvariablen (u_cell) bestimmt, die für die Funktionsweise dieser Zelle repräsentativ ist,
a3) es wird der Ladezustand der Zelle (SOCcell_est_i) mithilfe eines Zustandsbeobachters bestimmt, welcher auf dem in Schritt a1) bestimmten Wert der Eingangsvariablen (i_cell) basiert und welcher durch einen Korrekturparameter korrigiert ist, der aus dem in Schritt a2) bestimmten Wert der Ausgangsvariablen (u_cell) abgeleitet ist.

3. Verfahren nach Anspruch 2, wobei die Eingangsvariable wenigstens den durch die Zelle fließenden Strom (i_cell) umfasst.

4. Verfahren nach einem der Ansprüche 2 und 3, wobei die Ausgangsvariable wenigstens die Spannung an den Klemmen der Zelle (u_cell) umfasst.

5. Verfahren nach einem der Ansprüche 2 bis 4, wobei jede Zelle durch eine elektrische Modellschaltung modelliert wird, welche in Reihe einen Spannungsgenerator (OCV), einen Widerstand (R1) und eine Komponente, die einen Widerstand (R2) und einen Kondensator (C2), welche parallelgeschaltet sind, umfasst, aufweist.

6. Verfahren nach Anspruch 5, wobei die Werte der Widerstände (R1, R2) und der Kapazität (C2) des Kondensators der elektrischen Modellschaltung von der Temperatur der Zelle (temp_cell) und/oder vom Ladezustand (SOCcell) der Zelle und/oder von der Lebensdauer der Zelle abhängen.

7. Verfahren nach einem der Ansprüche 2 bis 6, wobei der Zustandsbeobachter ein Kalman-Filter (FK_i) aufweist.

8. Verfahren nach Anspruch 7, wobei das Kalman-Filter (FK_i) wenigstens einen Parameter aufweist, der von der Funktionsweise der Zelle abhängt.

9. Verfahren nach dem vorhergehenden Anspruch, wobei der Parameter des Kalman-Filters (FK_i) von der Funktion abhängt, welche die Leerlaufspannung der Zelle (OCV) und den Ladezustand der Zelle verknüpft.

10. Verfahren nach dem vorhergehenden Anspruch, wobei die Funktion, welche die Leerlaufspannung der Zelle (OCV) und den Ladezustand der Zelle verknüpft, eine affine Funktion ist und der Parameter des Kalman-Filters (FK_i) die Wachstumsrate (a) dieser Funktion ist.

11. Verfahren nach Anspruch 9, wobei die Funktion, welche die Leerlaufspannung der Zelle (OCV) und den Ladezustand der Zelle verknüpft, eine stückweise affine Funktion ist und für jeden Wertebereich des Ladezustands der Zelle, der einem anderen affinen Teil der die Leerlaufspannung der Zelle (OCV) und den Ladezustand der Zelle verknüpfenden Funktion zugeordnet ist, ein anderes Kalman-Filter (FK_i1, FK_i2, FK_i3, FK_i4) verwendet wird.

12. Verfahren nach dem vorhergehenden Anspruch, wobei das Kalman-Filter (FK_i1, FK_i2, FK_i3, FK_i4), das bei der Durchführung von Schritt a) zu einem gegebenen Zeitpunkt verwendet wird, in Abhängigkeit von dem Wert des geschätzten Ladezustands (SOCcell_est_i) der Zelle zum vorhergehenden Zeitpunkt bestimmt wird.

13. Verfahren nach einem der Ansprüche 11 und 12, wobei der Übergang zwischen einem ersten Kalman-Filter, das einem ersten Wertebereich des Ladezustands zugeordnet ist, und einem zweiten Kalman-Filter, das einem zweiten Wertebereich des Ladezustands zugeordnet ist, durch einen Automaten (A) verwaltet wird, der eine Hysterese aufweist.

14. Verfahren nach Anspruch 1, wobei in Schritt a) der Ladezustand jeder Zelle durch ein Verfahren der Amperestundenzählung bestimmt wird.

15. Verfahren nach dem vorhergehenden Anspruch, wobei in Schritt a)

  - der in die Batterie eingespeiste Strom integriert wird,
  - der Ladezustand jeder Zelle in Abhängigkeit vom Verhältnis zwischen dem Integral des in die Batterie eingespeisten Stroms und der Kapazität der betreffenden Zelle bestimmt wird.

16. Verfahren nach einem der vorhergehenden Ansprüche, wobei die betreffende Batterie eine Traktionsbatterie eines Kraftfahrzeugs ist.

**Claims**

1. Method of estimating the state of charge (SOCbatt_k) of an electric battery comprising a plurality of electric accumulators called cells, **characterized in that** it comprises the following steps:

   a) the state of charge (SOCcell_est_i) of each cell of the battery is determined,
   b) a range of use of the battery equal to a maximum predetermined value of the state of charge of a cell minus the deviation between the state of charge (SOCcell_max_k) of the most charged cell and the state of charge of the least charged cell (SOCcell_min_k) which are determined in step a) is determined,
   c) the state of charge of the battery (SOC_batt_k) is determined as being equal to the ratio between the state of charge of the least charged cell (SOCcell_min_k) determined in step a) and said range of use of the battery determined in step b).

2. Method according to Claim 1, wherein, in step a), the following steps are carried out for each cell of the battery:

   - a1) a value (I_cell_mes) of at least one input variable (i_cell) representative of the functioning of that cell is determined,
   - a2) a value (V_cell_mes) of at least one output variable (u_cell) representative of the functioning of that cell is determined,
   - a3) the state of charge of the cell (SOCcell_est_i) is estimated with the help of a state observer which is based on the value determined in step a1) of said input variable (i_cell) and which is corrected by a correction parameter derived from the value determined in step a2) of said output variable (u_cell).

3. Method according to Claim 2, wherein said input variable comprises at least the current passing through the cell (i_cell).

4. Method according to one of Claims 2 and 3, wherein said output variable comprises at least the voltage across the terminals of the cell (u_cell).

5. Method according to one of Claims 2 to 4, wherein each cell is modeled by an electric model circuit comprising in series a voltage (OCV) generator, a resistor (R1) and a component comprising a resistor (R2) and a capacitor (C2) in parallel.

6. Method according to Claim 5, wherein the values of the resistors (R1, R2) and of the capacity (C2) of the capacitor of the electric model circuit depend on the temperature of the cell (temp_cell) and/or on the state of charge (SOCcell) of the cell and/or on the lifetime of the cell.

7. Method according to one of Claims 2 to 6, wherein said state observer comprises a Kalman filter (FK_i).

8. Method according to Claim 7, wherein said Kalman filter (FK_i) comprises at least one parameter depending on the functioning of the cell.

9. Method according to the preceding claim, wherein said parameter of the Kalman filter (FK_i) depends on the function relating the open circuit voltage (OCV) of the cell and the state of charge of the cell.

10. Method according to the preceding claim, wherein the function relating the open circuit voltage (OCV) of the cell and the state of charge of the cell is an affine function and said parameter of the Kalman filter (FK_i) is the rate of growth (a) of this function.

11. Method according to Claim 9, wherein the function relating the open circuit voltage (OCV) of the cell and the state of charge of the cell is a piecewise affine function and a different Kalman filter (FK_i1, FK_i2, FK_i3, FK_i4) is used for each range of value of the state of charge of the cell associated with a different affine part of the function relating the open circuit voltage (OCV) of the cell and the state of charge of the cell.

12. Method according to the preceding claim, wherein the Kalman filter (FK_i1, FK_i2, FK_i3, FK_i4) used during the implementation of step a) at a given time is determined as a function of the value of the estimated state of charge of the cell (SOCcell_est_i) at the preceding time.

**13.** Method according to one of Claims 11 and 12, wherein the transition between a first Kalman filter associated with a first range of value of the state of charge and a second Kalman filter associated with a second range of values of the state of charge is managed by an automated system (A) having hysteresis.

**14.** Method according to Claim 1, wherein, in step a), the state of charge of each cell is determined by an amp-hour-metric metering method.

**15.** Method according to the preceding claim, wherein, in step a),

- the current entering the battery is integrated,
- the state of charge of each cell is determined as a function of the ratio between the integral of the current entering the battery and the capacity of the cell in question.

**16.** Method according to one of the preceding claims, wherein the battery in question is a traction battery of a motor vehicle.

Fig.1

## Fig.2

Fig.3

Fig.4

Fig.5

Fig.6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20050110498 A